# EUROPEAN PATENT APPLICATION

(11) **EP 4 550 419 A2**
(43) Date of publication of application: **07.05.2025**
(21) Application number: 24210410.7
(22) Date of filing: 01.11.2024
(51) Int. Cl.: H01L 23/66, H01Q 13/06, H01L 25/10, H01L 21/60

(54) **PACKAGE ON PACKAGE SEMICONDUCTOR DEVICE WITH INTEGRATED WAVEGUIDE AND METHOD THEREFOR**

(30) Priority: 03.11.2023 US 202318501108
(71) Applicant: NXP USA, Inc., Austin, TX 78735 (US)
(72) Inventor: VINCENT B., Michael, 5656AG Eindhoven (NL); MAHJABEEN, Nikita, 5656AG Eindhoven (NL)
(74) Representative: Hardingham, Christopher Mark

(57) **Abstract**

A method of forming a package-on-package semiconductor device is provided. The method includes mounting a packaged radio frequency (RF) semiconductor device on a first major side of a package substrate. The packaged RF semiconductor device includes a semiconductor die, an encapsulant encapsulating the semiconductor die, and a redistribution layer (RDL) formed over an active side of the semiconductor die and a portion of the encapsulant. A signal launcher is formed from a conductive layer of the RDL. The signal launcher is configured for propagation of an RF signal through a waveguide formed through the package substrate.

## Description

### Background

### Field

This disclosure relates generally to semiconductor device packaging, and more specifically, to package-on-package semiconductor devices with integrated waveguide and method of forming the same.

### Related Art

Today, there is an increasing trend to include sophisticated semiconductor devices in products and systems that are used every day. These sophisticated semiconductor devices may include features for specific applications which may impact the configuration of the semiconductor device packages, for example. For some higher performance features and applications, the configuration of the semiconductor device packages may be susceptible to performance constraints and higher product or system costs. Accordingly, significant challenges exist in accommodating these higher performance features and applications while enabling semiconductor devices' enhanced performance without significant costs impact.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in a simplified cross-sectional view, an example packaged radio frequency (RF) semiconductor device at a stage of manufacture in accordance with an embodiment.
FIG. 2 through FIG. 5 illustrate, in simplified cross-sectional views, an example package-on-package semiconductor device with the RF semiconductor device at various stages of manufacture in accordance with an embodiment.

### Detailed Description

Generally, there is provided, a package-on-package semiconductor device with interconnected RF semiconductor device. The RF semiconductor device is a packaged device that includes an RF semiconductor die, an encapsulant (e.g., epoxy molding compound) encapsulating the RF semiconductor die, and a redistribution layer formed over an active side of the RF semiconductor die and a portion of the encapsulant. A conductive layer of the redistribution layer is configured to form a signal launcher. The signal launcher is interconnected with a pad of the RF semiconductor die by way of the redistribution layer. A signal reflector is incorporated in the RF semiconductor device package and aligned with the signal launcher. The package-on-package semiconductor device includes a semiconductor die mounted on a top side of a package substrate. The package substrate is formed from a low cost, sub-terahertz performance, substrate-like PCB (SLP) substrate material. A waveguide configured for propagation of RF signals is formed through the package substrate. An antenna is mounted at a top opening of the waveguide at the top side of the package substrate. The semiconductor die and portions of the side of the package substrate encapsulated with an encapsulant. A cavity or opening is formed over the antenna such that the antenna and waveguide are void of encapsulant. The packaged RF semiconductor device is mounted on a bottom side of the package substrate such that the signal launcher is aligned with a bottom opening of the waveguide. By forming the package-on-package semiconductor device with interconnected RF semiconductor device in this manner, a low cost, low loss RF signal path from the RF semiconductor die through the waveguide and antenna can be realized.

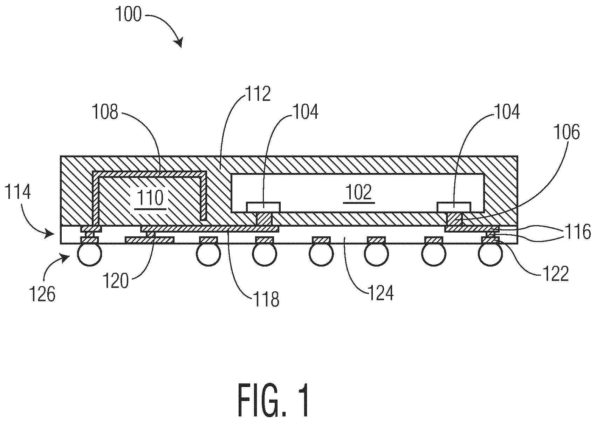

FIG. 1 illustrates, in a simplified cross-sectional view, an example packaged RF semiconductor device 100 at a stage of manufacture in accordance with an embodiment. At this stage of manufacture, the RF semiconductor device 100 includes a semiconductor die 102, an encapsulant 112 (e.g., epoxy molding compound) encapsulating the semiconductor die, and a redistribution layer (RDL) 114 formed over an active side of the semiconductor die and a portion of the encapsulant. In this embodiment, the RDL 114 includes a signal launcher 120 formed from a conductive layer of the RDL. A corresponding conductive signal reflector 108 is aligned with the signal launcher 120 and integrated adjacent to the semiconductor die 102. The term "conductive," as used herein, generally refers to electrical conductivity unless otherwise described. In this embodiment, the signal reflector 108 is formed as a metal base portion and metal sidewall portions configured to substantially form a metal lined cavity 110. The base portion of the signal reflector 108 is located on an opposing side of the cavity 110 from the signal launcher 120 and in a plane substantially parallel with a plane of the signal launcher 120. In this embodiment, the cavity 110 is shown filled with the encapsulant 112. In some embodiments, the cavity may be air filled or filled with a low Df/Dk dielectric material. In some embodiments, the packaged RF semiconductor device 100 may be characterized as a launcher-in-package device formed as a wafer-level package, for example.

The semiconductor die 102 has the active side (e.g., major side having circuitry) and a backside (e.g., major side opposite of the active side). The semiconductor die 102 includes bond pads 104 formed at the active side and configured for connection to conductive features of the RDL 114 by way of conductive die connectors 106, for example. In this embodiment, semiconductor die 102 is configured in an active-side-down orientation with a die pad 104 at the active side interconnected to the signal launcher 120 by way of the RDL 114 without any solder connections. The semiconductor die 102 may be formed from any suitable semiconductor material, such as silicon, germanium, gallium arsenide, gallium nitride, and the like. In this embodiment, the semiconductor die 102 is characterized as an RF semiconductor die configured to transmit and/or receive RF signals by way of the signal launcher 120 formed in the RDL 114.

The interconnecting RDL 114 is applied over the active side of the encapsulated semiconductor die 102 and cavity 110 of the signal reflector 108. The RDL 114 includes conductive features such as metal traces and vias 116, signal launcher 120 and interconnecting trace 118, and connector pads 122 surrounded by non-conductive material 124. The RDL 114 may be formed as a multi-layer build-up RDL or may be provided as a pre-formed laminate RDL, for example. In this embodiment, the die pad 104 is interconnected to the signal launcher 120 by way of the metal trace 118 of the RDL 114 to form a substantially direct low-loss RF signal path from the semiconductor die 102 to the signal launcher 120. Other signal traces and ground plane and/or ground shield traces of the RDL are not shown for illustration purposes. After the RDL 114 is applied, low-profile conductive connectors 126 are affixed to RDL connector pads 122. The low-profile conductive connectors 126 are configured and arranged to provide conductive connections between the packaged RF semiconductor device 100 and a package substrate at a subsequent stage, for example. In this embodiment, the metal signal reflector 108 may be conductively connected to a ground voltage supply by way of the RDL 114 and respective low-profile conductive connector 126. The conductive connectors 126 may be in the form of suitable conductive structures such as solder balls, gold studs, copper pillars, and the like.

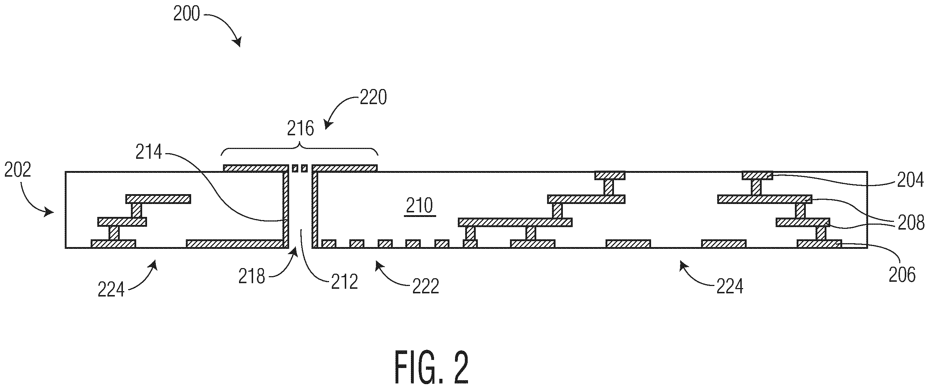

FIG. 2 through FIG. 5 illustrate, in simplified cross-sectional views, an example package-on-package semiconductor device 200 with attached RF semiconductor device 100 at various stages of manufacture in accordance with an embodiment.

FIG. 2 illustrates, in a simplified cross-sectional view, the example package-on-package semiconductor device 200 at a stage of manufacture in accordance with an embodiment. At this stage, the package-on-package semiconductor device 200 includes a package substrate 202 having a top major side and a bottom major side. In this embodiment, the package substrate 202 includes conductive features such as a plurality of top side conductive pads 204, a plurality of bottom side conductive pads 206, conductive traces 208, and a waveguide 212 surrounded by a non-conductive material 210 (e.g., dielectric). The top side conductive pads 204 are exposed at the top major surface of the package substrate 202 and configured for connections to a packaged RF semiconductor die at a subsequent stage of manufacture, for example. The bottom side conductive pads 206 are exposed at the bottom major surface of the package substrate 202. A first portion 222 of the bottom side conductive pads 206 are configured for conductive connections to the packaged RF semiconductor device 100 by way of the low-profile conductive connectors 126 of FIG. 1 at a subsequent stage of manufacture. For example, the first portion 222 of the bottom side conductive pads 206 are formed in predetermined locations such that when the packaged RF semiconductor device 100 is mounted to the package substrate 202, the signal launcher (120 of FIG. 1) is properly aligned with the waveguide 212. A second portion 224 of the bottom side conductive pads 206 are configured for connections to a printed circuit board (PCB) by way of conductive connectors (e.g., solder balls) at a subsequent stage, for example. In this embodiment, the package substrate 202 is formed from a low cost, commercially available substrate-like PCB (SLP) substrate material.

In this embodiment, the waveguide 212 is formed through the package substrate 202. The waveguide 212 includes a top opening 220 at the top major side and a bottom opening 218 at the bottom major side. A conductive lining 214 is formed on the sidewall surfaces of the waveguide 212. For example, the conductive lining 214 may be formed as a metal layer or coating on the sidewall surfaces by way of plating operation. The conductive lining 214 of the waveguide 212 extends from the top opening 220 at the top major side of the package substrate 202 to the bottom opening 218 at the bottom major side of the package substrate. In this embodiment, the conductive lining may be conductively connected to a ground voltage supply by way of the conductive features of the package substrate 202. The waveguide 212, as depicted in FIG. 2, is configured as an RF signal pathway straight through (e.g., no bends or jogs) the package substrate 202. By forming the waveguide 212 in this manner, the RF signal pathway is the shortest possible distance through the package substrate 202. Even though the waveguide 212 of FIG. 2 is depicted in a "straight through" configuration, embodiments with other waveguide configurations such as waveguides including bends or jogs are anticipated by this disclosure.

In this embodiment, an antenna 216 is affixed on the top major side of the package substrate 202. The antenna 216 is aligned and applied directly over the top opening 220 of the waveguide 212 to facilitate propagation (e.g., transmission, reception) of an RF signal. The antenna 216 may be formed directly on the top major side of the package substrate 202 or may be provided as a pre-formed antenna structure and attached on the top major side by way of an adhesive (not shown), for example. In some embodiments, the antenna 216 may be characterized as a slot antenna. In this embodiment, the antenna 216 is conductively connected to the conductive lining 214 of the waveguide 212 at the top major side of the package substrate 202.

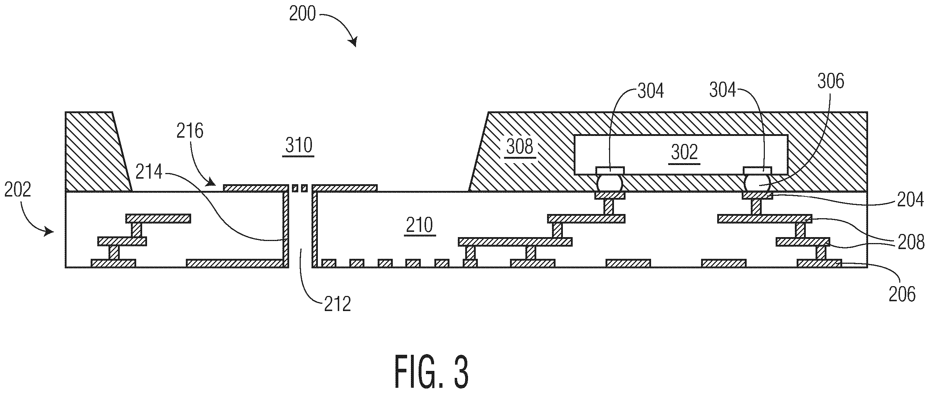

FIG. 3 illustrates, in a simplified cross-sectional view, the example package-on-package semiconductor device 200 at a subsequent stage of manufacture in accordance with an embodiment. At this stage, the package-on-package semiconductor device 200 includes a semiconductor die 302 mounted on the package substrate 202 and encapsulated with an encapsulant 308 (e.g., epoxy molding compound). Bond pads 304 at the active side of the semiconductor die 302 are conductively connected to the top side conductive pads 204 at the top major surface of the package substrate 202 by way of conductive die connectors 306. The conductive die connectors 306 are configured and arranged to provide conductive connections between the semiconductor die 302 and conductive features of the package substrate 202, for example. The conductive die connectors 306 may be in the form of suitable conductive structures such as solder balls, gold studs, copper pillars, and the like.

In this embodiment, the semiconductor die 302 and portions of the top major side of the package substrate 202 are over-molded with the encapsulant 308 by way of a molding process such as a film-assisted molding (FAM) process. For example, a FAM tool using a conformal film may be engaged with a predetermined portion (e.g., antenna 216 region) of the top major side of the package substrate 202 during the molding process to form a cavity 310 in the encapsulant 308. In this manner, the antenna 216 and immediate surrounding surface at the top major side of the package substrate 202, for example, may be exposed at the bottom of the cavity 310. Alternatively, the semiconductor die 302 and portions of the top major side of the package substrate 202 may be encapsulated with the encapsulant 308 during an injection molding operation, for example, having the cavity 310 subsequently formed by way of laser ablation or selective etching. In some embodiments, the cavity 310 may be configured as an antenna horn having a metal layer or coating (not shown) formed on the sidewall surfaces surrounding the antenna 216.

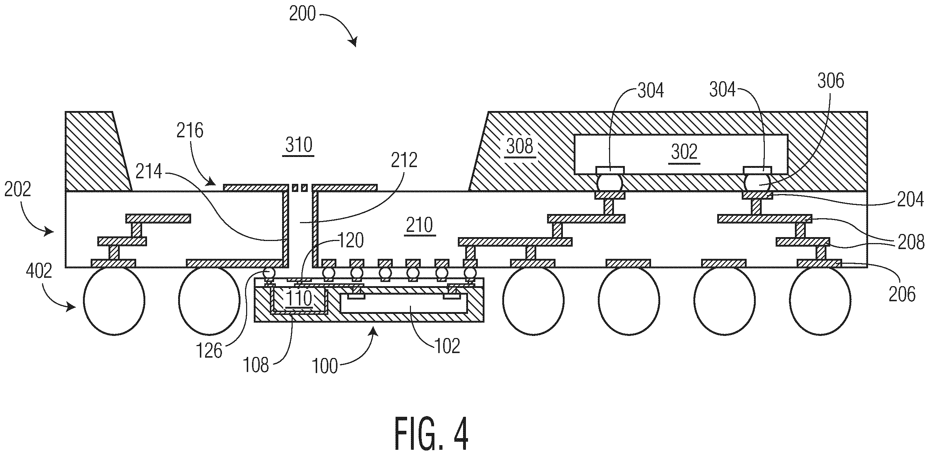

FIG. 4 illustrates, in a simplified cross-sectional view, the example package-on-package semiconductor device 200 at a subsequent stage of manufacture in accordance with an embodiment. At this stage, the package-on-package semiconductor device 200 includes the packaged RF semiconductor device 100 mounted on the bottom major side of the package substrate. In this embodiment, the packaged RF semiconductor device 100 is conductively connected to the first portion (222 of FIG. 2) of the bottom side conductive pads 206 of the package substrate 202 by way of the low-profile conductive connectors 126. With the RF semiconductor device 100 attached to the package substrate 202, the signal launcher 120 formed in the RDL of the packaged RF semiconductor device 100 is substantially aligned with waveguide 212 of the package substrate 202. Accordingly, a substantially direct low-loss RF signal path from the semiconductor die 102 to the signal launcher 120 of the packaged RF semiconductor device 100 persists through the waveguide 212 and antenna 216 at the top major surface of the package substrate 202. In this embodiment, the metal signal reflector 108 of the packaged RF semiconductor device 100 may be conductively connected to a ground voltage supply by way of the package substrate 202 and respective one or more low-profile conductive connectors 126.

In this embodiment, a plurality of conductive package connectors 402 (e.g., solder balls) are affixed to the second portion (224 of FIG. 2) of the bottom side conductive pads 206 of the package substrate 202. The conductive package connectors 402 are configured and arranged to provide conductive connections between the package substrate 202 and a PCB, for example. Accordingly, the semiconductor die 302 may be interconnected with the packaged RF semiconductor device 100 as well as the PCB by way of the conductive features of the package substrate 202. The conductive package connectors 402 may be in the form of suitable conductive structures such as solder balls, gold studs, copper pillars, and the like, to connect conductive features of the example package-on-package semiconductor device 200 with the PCB.

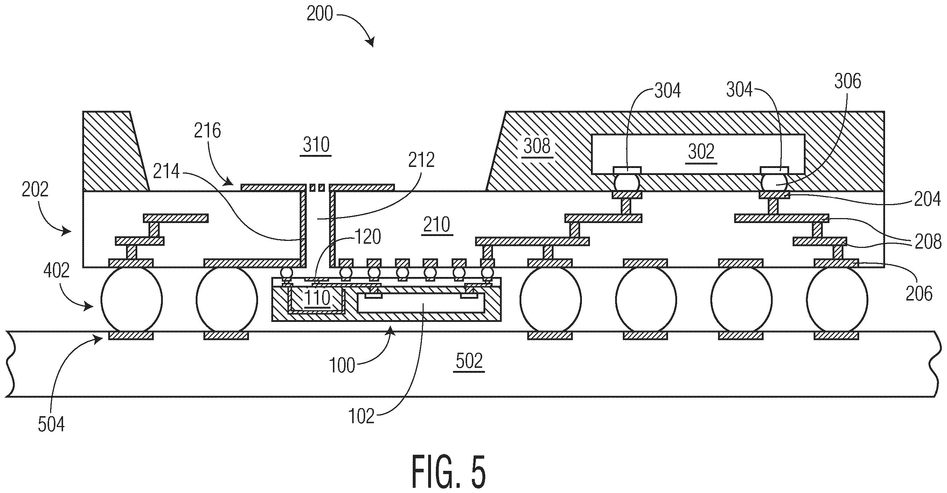

FIG. 5 illustrates, in a simplified cross-sectional view, the example package-on-package semiconductor device 200 at a subsequent stage of manufacture in accordance with an embodiment. At this stage, the package-on-package semiconductor device 200 with attached packaged RF semiconductor device 100 is mounted on an example PCB 502. In this embodiment, the package substrate 202 of the package-on-package semiconductor device 200 is interconnected with the PCB 502 by way of the plurality of conductive package connectors 402. For example, the second portion (224 of FIG. 2) of the bottom side conductive pads 206 of the package substrate 202 is conductively connected to respective connection pads 504 exposed at a top side of the PCB 504 by way of the conductive package connectors 402. In this manner, semiconductor die 102 of the packaged RF semiconductor device 100 and semiconductor die 302 may be interconnected with conductive features of the PCB 502.

Generally, there is provided, a method including providing a package substrate, a waveguide formed through the package substrate; and mounting a packaged radio frequency (RF) semiconductor device on a first major side of the package substrate, the packaged RF semiconductor device including a semiconductor die, an encapsulant encapsulating the semiconductor die, and a redistribution layer (RDL) formed over an active side of the semiconductor die and a portion of the encapsulant, a signal launcher formed from a conductive layer of the RDL and configured for propagation of an RF signal through the waveguide. The method may further include affixing an antenna on a second major side of the package substrate, the antenna directly aligned with the waveguide. The waveguide formed through the package substrate may be formed as an air-filled waveguide. The sidewall surfaces of the waveguide may be plated with a metal material to form a metal lining of the waveguide. A die pad at the active side of the semiconductor die may be interconnected to the signal launcher by way of the RDL. The packaged RF semiconductor device may be characterized as a launcher-in-package formed as a wafer-level package. The package substrate may be formed from a substrate-like PCB (SLP) substrate material. The method may further include mounting a second semiconductor die onto the second major side of the package substrate, the second semiconductor die interconnected with the packaged RF semiconductor device by way of the package substrate. The method may further include encapsulating with a second encapsulant the second semiconductor die and portions of the second major side of the package substrate.

In another embodiment, there is provided, a semiconductor device including a package substrate including a waveguide formed through the package substrate; and a packaged radio frequency (RF) semiconductor device mounted on a first major side of the package substrate, the packaged RF semiconductor device including a semiconductor die, an encapsulant encapsulating the semiconductor die, and a redistribution layer (RDL) formed over an active side of the semiconductor die and a portion of the encapsulant, a signal launcher formed from a conductive layer of the RDL and configured for propagation of an RF signal through the waveguide. The semiconductor device may further include an antenna affixed on a second major side of the package substrate, the antenna directly aligned with the waveguide. A die pad at the active side of the semiconductor die may be interconnected to the signal launcher by way of the RDL. A signal path may be formed from the die pad at the active side of the semiconductor die to the signal launcher of the RDL without any solder connections. The semiconductor device may further include a conductive lined cavity formed in the encapsulant and located directly below the signal launcher, the conductive cavity configured as a signal reflector. The semiconductor device may further include a second semiconductor die mounted on the second major side of the package substrate, the second semiconductor die interconnected with the packaged RF semiconductor device by way of the package substrate.

In yet another embodiment, there is provided, a method including providing a package substrate having a waveguide formed through the package substrate, the waveguide including a first opening at a first major side of the package substrate and a second opening at a second major side of the package substrate; affixing an antenna on the second major side of the package substrate, the antenna aligned directly over the second opening of the waveguide; and mounting a packaged radio frequency (RF) semiconductor device on the first major side of the package substrate, the packaged RF semiconductor device including a semiconductor die, an encapsulant encapsulating the semiconductor die, and a redistribution layer (RDL) formed over an active side of the semiconductor die and a portion of the encapsulant, a signal launcher formed from a conductive layer of the RDL and configured for propagation of an RF signal through the waveguide. A die pad at the active side of the semiconductor die is interconnected to the signal launcher by way of the RDL without any solder connections. The waveguide may further include a metal lining that extends from the first opening at the first major side of the package substrate to the second opening at the second major side of the package substrate, the metal lining conductively connected to the antenna. The antenna affixed on the second major side of the package substrate may be characterized as a slot antenna. The method may further include mounting a second semiconductor die onto the second major side of the package substrate, the second semiconductor die interconnected with the packaged RF semiconductor device by way of the package substrate.

By now, it should be appreciated that there has been provided, a package-on-package semiconductor device with interconnected RF semiconductor device. The RF semiconductor device is a packaged device that includes an RF semiconductor die, an encapsulant (e.g., epoxy molding compound) encapsulating the RF semiconductor die, and a redistribution layer formed over an active side of the RF semiconductor die and a portion of the encapsulant. A conductive layer of the redistribution layer is configured to form a signal launcher. The signal launcher is interconnected with a pad of the RF semiconductor die by way of the redistribution layer. A signal reflector is incorporated in the RF semiconductor device package and aligned with the signal launcher. The package-on-package semiconductor device includes a semiconductor die mounted on a top side of a package substrate. The package substrate is formed from a low cost, sub-terahertz performance, substrate-like PCB (SLP) substrate material. A waveguide configured for propagation of RF signals is formed through the package substrate. An antenna is mounted at a top opening of the waveguide at the top side of the package substrate. The semiconductor die and portions of the side of the package substrate encapsulated with an encapsulant. A cavity or opening is formed over the antenna such that the antenna and waveguide are void of encapsulant. The packaged RF semiconductor device is mounted on a bottom side of the package substrate such that the signal launcher is aligned with a bottom opening of the waveguide. By forming the package-on-package semiconductor device with interconnected RF semiconductor device in this manner, a low cost, low loss RF signal path from the RF semiconductor die through the waveguide and antenna can be realized.

The terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Although the invention is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

## Claims

1. A method comprising:
providing a package substrate, a waveguide formed through the package substrate; and
mounting a packaged radio frequency (RF) semiconductor device on a first major side of the package substrate, the packaged RF semiconductor device comprising:
a semiconductor die,
an encapsulant encapsulating the semiconductor die, and
a redistribution layer (RDL) formed over an active side of the semiconductor die and a portion of the encapsulant, a signal launcher formed from a conductive layer of the RDL and configured for propagation of an RF signal through the waveguide.

2. The method of claim 1, further comprising affixing an antenna on a second major side of the package substrate, the antenna directly aligned with the waveguide.

3. The method of claim 1, wherein the waveguide formed through the package substrate is formed as an air-filled waveguide.

4. The method of claim 1, wherein sidewall surfaces of the waveguide are plated with a metal material to form a metal lining of the waveguide.

5. The method of claim 1, wherein a die pad at the active side of the semiconductor die is interconnected to the signal launcher by way of the RDL.

6. The method of claim 1, wherein the packaged RF semiconductor device is characterized as a launcher-in-package formed as a wafer-level package.

7. The method of claim 1, wherein the package substrate is formed from a substrate-like PCB (SLP) substrate material.

8. The method of claim 1, further comprising mounting a second semiconductor die onto the second major side of the package substrate, the second semiconductor die interconnected with the packaged RF semiconductor device by way of the package substrate.

9. The method of claim 8, further comprising encapsulating with a second encapsulant the second semiconductor die and portions of the second major side of the package substrate.

10. A method comprising:
providing a package substrate having a waveguide formed through the package substrate, the waveguide including a first opening at a first major side of the package substrate and a second opening at a second major side of the package substrate;
affixing an antenna on the second major side of the package substrate, the antenna aligned directly over the second opening of the waveguide; and
mounting a packaged radio frequency (RF) semiconductor device on the first major side of the package substrate, the packaged RF semiconductor device comprising:
a semiconductor die,
an encapsulant encapsulating the semiconductor die, and
a redistribution layer (RDL) formed over an active side of the semiconductor die and a portion of the encapsulant, a signal launcher formed from a conductive layer of the RDL and configured for propagation of an RF signal through the waveguide.

11. The method of claim 10, wherein a die pad at the active side of the semiconductor die is interconnected to the signal launcher by way of the RDL without any solder connections.

12. The method of claim 10 or 11, wherein the waveguide further includes a metal lining that extends from the first opening at the first major side of the package substrate to the second opening at the second major side of the package substrate, the metal lining conductively connected to the antenna.

13. The method of any of claims 10 to 12, wherein the antenna affixed on the second major side of the package substrate is characterized as a slot antenna.

14. The method of any of claims 10 to 13, further comprising mounting a second semiconductor die onto the second major side of the package substrate, the second semiconductor die interconnected with the packaged RF semiconductor device by way of the package substrate.
